# EUROPEAN PATENT APPLICATION

(11) **EP 4 503 116 A1**
(43) Date of publication of application: **05.02.2025**
(21) Application number: 23856197.1
(22) Date of filing: 09.06.2023
(51) Int. Cl.: H01L 23/13

(54) **MOSFET PACKAGING STRUCTURE AND MANUFACTURING METHOD THEREFOR, CIRCUIT BOARD ASSEMBLY, AND ELECTRONIC DEVICE**

(30) Priority: 22.08.2022 CN 202211008429
(71) Applicant: Honor Device Co., Ltd., Shenzhen, Guangdong 518040 (CN)
(72) Inventor: WANG, Quanlong, Shenzhen, Guangdong 518040 (CN); HUANG, Song, Shenzhen, Guangdong 518040 (CN)
(74) Representative: Goddar, Heinz J.
(86) International application number: PCT/CN2023/099537
(87) International publication number: WO 2024/041105

(57) **Abstract**

This application provides a MOSFET packaging structure and a manufacturing method thereof, a circuit board assembly, and an electronic device. In the MOSFET packaging structure, a MOSFET chip is mounted on a carrier chip. An interconnect distance between the MOSFET chip and the carrier chip is short and a parasitic inductance is small, making it easy to implement high-frequency driving. In addition, three conductive members are mounted on a second surface of the MOSFET chip to electrically connect to an input gasket, an output gasket, and a ground gasket of the MOSFET chip respectively. The conductive members not only have high current carrying capacity, but also can reduce resistance of interconnection, so that heat generated by the MOSFET chip is reduced and heat dissipation performance of the MOSFET chip is improved. In addition, the MOSFET packaging structure has a small packaging volume, which is conducive to a miniaturization design.

## Description

This application claims priority to Chinese Patent Application No. 202211008429.6, filed with the China National Intellectual Property Administration on August 22, 2022, and entitled "MOSFET PACKAGING STRUCTURE AND MANUFACTURING METHOD THEREOF, CIRCUIT BOARD ASSEMBLY, AND ELECTRONIC DEVICE", which is incorporated herein by reference in its entirety.

### TECHNICAL FIELD

This application relates to the field of semiconductor packaging technologies, and in particular, to a MOSFET packaging structure and a manufacturing method thereof, a circuit board assembly, and an electronic device.

### BACKGROUND

With the trend towards thinness, low power consumption, and diverse functions of consumer electronics, there is a requirement for integrating an increasing quantity of components on a main board, as a result, space reserved for components becomes increasingly smaller. A packaged chip has to be lightweight and compact, to provide greater choices between thinness and high performance for a product design.

A metal-oxide-semiconductor field-effect transistor (Metal-Oxide-Semiconductor Field-Effect Transistor, MOSFET) is a field-effect transistor that uses an electric field effect to control a semiconductor. With a capability of implementing low-power voltage control, the MOSFET has been widely used in electronic devices (for example, mobile phones) in recent years. Compared with a conventional silicon MOS, a gallium nitride (GaN) MOS has lower on-resistance, a faster switching speed, and a lower switching loss, and therefore has a wide range of applications. Currently, the gallium nitride MOS is mostly packaged as a discrete device and driven by a separate driver.

However, the independently packaged gallium nitride MOS and driver occupy a large volume and require a large quantity of leads to implement an electrical connection. The leads introduce a parasitic inductance, leading to a switching loss or another problem.

### SUMMARY

This application provides a MOSFET packaging structure and a manufacturing method thereof, a circuit board assembly, and an electronic device. The MOSFET packaging structure, with a simple structure, a small volume, and a small parasitic inductance, can achieve high current carrying and low thermal resistance, and solve a switching loss problem or the like.

According to a first aspect, this application provides a MOSFET packaging structure, including a carrier chip, a MOSFET chip, and three conductive members.

A surface on one side of the carrier chip is a mounting surface, a plurality of first pads are distributed on the mounting surface, the mounting surface has a mounting region, and the plurality of first pads are provided in the mounting region. The MOSFET chip has a first surface and a second surface opposite to each other, and the first surface is mounted in the mounting region and connected to the first pads in the mounting region. The three conductive members are all mounted on the second surface at intervals.

The MOSFET chip includes an input gasket, an output gasket, and a ground gasket, and the three conductive members are electrically connected to the input gasket, the output gasket, and the ground gasket respectively.

In the MOSFET packaging structure provided by this application, the first surface of the MOSFET chip is mounted in the mounting region of the carrier chip, and a control signal interconnect between the MOSFET chip and the carrier chip is implemented through the first pad on the carrier chip. An interconnect distance between the MOSFET chip and the carrier chip is short and a parasitic inductance is small, making it easy to implement high-frequency driving. In addition, a MOSFET assembly is formed by mounting the conductive members on the second surface of the MOSFET chip. The input gasket, the output gasket, and the ground gasket on the MOSFET chip are high current passing regions. By setting the three conductive members to be respectively electrically connected to the input gasket, the output gasket, and the ground gasket, high current regions of the MOSFET chip are interconnected with a circuit board through the conductive members. The conductive members not only have a high current carrying capacity, but also can reduce resistance of the interconnection. The MOSFET chip generates less heat, and the conductive members have strong thermal conductivity, so that heat dissipation performance of the MOSFET chip can be effectively improved. In addition, the MOSFET assembly is directly mounted on the carrier chip to form a MOSFET packaging structure. A packaging volume is small, which is conducive to miniaturization of the MOSFET packaging structure.

When the MOSFET packaging structure is packaged on the circuit board, the high current region of the MOSFET chip is interconnected with the circuit board through the conductive member. Another region of the MOSFET chip and the circuit board, and the carrier chip and the circuit board are interconnected through the conductive material.

In a possible implementation, the input gasket, the output gasket, and the ground gasket are all located on a side on which the first surface is located. The first pads in the mounting region include an input pad, an output pad, and a ground pad. The input gasket is correspondingly connected to the input pad, the output gasket is correspondingly connected to the output pad, and the ground gasket is correspondingly connected to the ground pad.

The input gasket, the output gasket, and the ground gasket are provided on the first surface of the MOSFET chip. The first surface of the MOSFET chip is an active surface of the MOSFET chip. This facilitates transmission, by the carrier chip, a driving signal to the active surface of the MOSFET chip. In this case, by providing the input pad, the output pad, and the ground pad respectively corresponding to the input gasket, the output gasket, and the ground gasket in the mounting region of the carrier chip, high current transmission can be implemented between the MOSFET chip and the circuit board.

In a possible implementation, the conductive member is a conductive frame. The conductive frame includes a main plate portion and side plate portions. The main plate portion covers the second surface. One end of each of the side plate portions is connected to a side edge of the main plate portion, and the other end of the side plate portion extends toward the carrier chip.

The side plate portions of the three conductive frames are respectively connected to the input pad, the output pad, and the ground pad.

By providing the conductive frame that includes the main plate portion and the side plate portions, the main plate portion is correspondingly attached to the second surface of the MOSFET chip, the side plate portion is connected to the side edge of the main plate portion and protrudes towards the carrier chip, and the side plate portions each is connected to the first pad on the carrier chip through the conductive material, so that the conductive frame is connected to the corresponding input gasket, the output gasket or the ground gasket on the MOSFET chip through the first pad, and high current transmission is implemented between the circuit board and the MOSFET chip.

In a possible implementation, an adhesive layer is provided between the conductive frame and the MOSFET chip.

The conductive frame is an independent structural member. By providing the adhesive layer between the conductive frame and the MOSFET chip, the MOSFET chip is mounted on the conductive frame to form a MOSFET assembly.

In a possible implementation, the conductive frame includes a copper frame or a copper alloy frame.

The copper or copper alloy material is used to make the conductive frame. Copper and copper alloy have high electrical conductivity and thermal conductivity. Using the copper frame as the conductive member not only can achieve a high current carrying capacity of the conductive member, but also can efficiently dissipate heat generated by the MOSFET chip to the outside, which can improve performance of the MOSFET packaging structure.

In a possible implementation, the input gasket, the output gasket, and the ground gasket are all located on a side on which the second surface is located, and the three conductive members respectively cover the input gasket, the output gasket, and the ground gasket.

For a case that the input gasket, the output gasket, and the ground gasket are all provided on the side on which the second surface of the MOSFET chip is located, the three conductive members mounted on the second surface of the MOSFET chip can respectively cover the input gasket, the output gasket, and the ground gasket, to implement connection of each the input gasket, the output gasket, and the ground gasket to the corresponding conductive member.

In a possible implementation, the conductive member is a conductive layer covering the second surface.

The conductive layer is deposited on the second surface of the MOSFET chip, so that conductive layers cover the corresponding input gasket, output gasket, and ground gasket, and electrical connection of each of the input gasket, the output gasket, and the ground gasket to the corresponding conductive layer is implemented.

In a possible implementation, the conductive layer includes a copper layer or an aluminum layer.

By setting the conductive layer as a copper layer or an aluminum layer, it can be ensured that the conductive layer has high electrical conductivity and thermal conductivity. In this way, the conductive layer not only can achieve the high current carrying capacity of the conductive member, but also can efficiently dissipate heat generated by the MOSFET chip to the outside, which can improve performance of the MOSFET packaging structure.

In a possible implementation, a plurality of conductive gaskets are also distributed on the first surface, and the conductive gaskets are connected to the first pads in the mounting region in a one-to-one correspondence.

By providing the conductive gaskets, the conductive gaskets are electrically connected to the first pads on the carrier chip, thereby implementing transmission of a driving signal between the MOSFET chip and the carrier chip. By providing the conductive gaskets on the first surface of the MOSFET chip, the conductive gaskets are opposite to the first pads, and the two are connected through the conductive materials, so that an interconnect distance of a driving signal between the MOSFET chip and the carrier chip is short and a parasitic inductance is small, making it easy to implement high-frequency driving.

In a possible implementation, the MOSFET chip is a GaN MOSFET.

The MOSFET chip is set as the GaN MOSFET. The GaN MOSFET has lower on-resistance and a faster switching speed, which can reduce an area of peripheral components and reduce a volume of the MOSFET packaging structure. Further, the GaN MOSFET can effectively reduce a switching loss, and improve power efficiency.

In a possible implementation, the carrier chip includes a chip body, a dielectric layer, and a wiring layer.

The dielectric layer covers the chip body, the wiring layer is provided in the dielectric layer, a side of the wiring layer facing the chip body is connected to a conductive structure in the chip body, a surface on a side of the wiring layer facing away from the chip body has exposed regions exposed outside the dielectric layer, and the first pads correspond to the exposed region.

By providing the insulating dielectric layer on the chip body, the wiring layer is provided in the dielectric layer, and the dielectric layer protects the wiring layer. Conductive wires in the wiring layer are connected to the conductive structure in the chip body. The dielectric layer implements electrical isolation of the conductive wires from another region on the chip body. In addition, the surface on the side of the wiring layer facing away from the chip body has an exposed region. The exposed regions are exposed outside the dielectric layer, and the first pads are provided corresponding to the exposed regions, so as to implement electrical connection between the carrier chip, the MOSFET chip, and the circuit board.

In a possible implementation, the dielectric layer includes a first dielectric layer and a second dielectric layer successively stacked on the chip body, and the wiring layer is provided between the first dielectric layer and the second dielectric layer.

Through holes are provided in the first dielectric layer, and the wiring layer is electrically connected to the chip body through the through holes; and the second dielectric layer has an opening, and the exposed region is exposed in the opening.

By disposing the first dielectric layer on the chip body, the wiring layer is disposed on the first dielectric layer, and the conductive wires in the wiring layer are connected to the conductive structure in the chip body through the through holes in the first dielectric layer. The first dielectric layer electrically isolates the wiring layer from another region of the chip body. By stacking the second dielectric layer on the first dielectric layer, the second dielectric layer covers the wiring layer to protect the wiring layer. By providing the opening in the second dielectric layer, a partial region of the conductive wires is exposed in the opening, so that the first pads are provided correspondingly in the exposed regions of the conductive wires, to implement electrical connection between the carrier chip, the MOSFET chip, and the circuit board.

According to a second aspect, this application provides a manufacturing method of a MOSFET packaging structure, including:
providing a plurality of MOSFET assemblies, where the MOSFET assemblies each include a MOSFET chip and three conductive members, the MOSFET chip has a first surface and a second surface opposite to each other, the three conductive members are all mounted on the second surface at intervals, the MOSFET chip includes an input gasket, an output gasket, and a ground gasket, and the three conductive members are electrically connected to the input gasket, the output gasket, and the ground gasket respectively;
providing a wafer, where the wafer includes a plurality of chip bodies arranged in an array;
forming a dielectric layer and a wiring layer on a surface on one side of the wafer, where the dielectric layer covers the wafer, the wiring layer is provided in the dielectric layer, a side of the wiring layer facing the wafer is connected to conductive structures in the chip bodies, a surface on a side of the wiring layer facing away from the wafer has exposed regions exposed outside the dielectric layer, and the exposed regions form first pads correspondingly;
mounting the MOSFET assemblies on the wafer, where first surfaces of the MOSFET chips are connected to the first pads through conductive materials; and
cutting the wafer to form separate MOSFET packaging structures.

According to the manufacturing method of a MOSFET packaging structure provided by this application, after the plurality of MOSFET assemblies are provided, and the dielectric layer and the wiring layer are formed on a surface of the wafer, each MOSFET assembly is mounted in a region, on the wafer, corresponding to each carrier chip, and then the wafer is cut to form a plurality of separate MOSFET packaging structures. In this way, through the wafer-level chip packaging manner, a volume of the MOSFET packaging structure is reduced, which is conducive to miniaturization of the MOSFET packaging structure. In addition, packaging process steps are simplified, packaging costs are reduced, and packaging efficiency is improved.

In a possible implementation, the input gasket, the output gasket, and the ground gasket are all located on a side on which the first surface is located, and the providing MOSFET assemblies includes:
providing a conductive frame as the conductive member, where the conductive frame includes a main plate portion and side plate portions, one end of each of the side plate portions is connected to a side edge of the main plate portion, and the other end of the side plate portion faces a side of the main plate portion; and
connecting the MOSFET chip to the conductive frame, where the MOSFET chip is located in a region enclosed by the main plate portion part and the side plate portions.

In a possible implementation, the providing a plurality of MOSFET assemblies includes:
providing a conductive plate;
processing the conductive plate to form a plurality of interconnected conductive frames;
correspondingly connecting each MOSFET chip to each conductive frame; and
cutting the conductive plate to form the plurality of MOSFET assemblies.

By providing the conductive plate, the conductive plate is first processed into a plurality of interconnected conductive frames, each MOSFET chip is mounted on a corresponding conductive frame, and then the conductive plate is cut to form the plurality of individual MOSFET assemblies. In this way, the plurality of MOSFET assemblies can be formed at the same time, that is, the MOSFET assemblies can be manufactured in batches, which improves manufacturing efficiency of MOSFET assemblies.

In a possible implementation, the processing the conductive plate includes:
using a photolithography process or a stamping for molding process to form the plurality of interconnected conductive frames on the conductive plate.

In a possible implementation, the input gasket, the output gasket, and the ground gasket are all located on a side on which the second surface is located, and the providing MOSFET assemblies includes:
providing the MOSFET chip; and
forming a conductive layer on the second surface of the MOSFET chip, where the conductive layer serves as a conductive member, and three conductive layers cover the input gasket, the output gasket, and the ground gasket respectively.

In a possible implementation, the forming a dielectric layer and a wiring layer on a surface on one side of the wafer includes:
forming a first dielectric layer having through holes on the surface on one side of the wafer;
laying the wiring layer on the first dielectric layer, where the wiring layer is electrically connected to the chip body through the through holes; and
forming a second dielectric layer having an opening on the first dielectric layer, where the second dielectric layer covers the wiring layer, and the exposed region is exposed in the opening.

According to a third aspect, this application provides a circuit board assembly, including a circuit board and the MOSFET packaging structure described above. A plurality of second pads are distributed on the circuit board, and the MOSFET packaging structure is connected to the second pad through a conductive material.

The circuit board assembly provided by this application includes the circuit board and the MOSFET packaging structure mounted on the circuit board. In the MOSFET packaging structure, a first surface of a MOSFET chip is mounted in a mounting region of a carrier chip, and a control signal interconnect between the MOSFET chip and the carrier chip is implemented through the first pad on the carrier chip. An interconnect distance between the MOSFET chip and the carrier chip is short and a parasitic inductance is small, making it easy to implement high-frequency driving. In addition, a MOSFET assembly is formed by mounting conductive members on a second surface of the MOSFET chip. An input gasket, an output gasket, and a ground gasket on the MOSFET chip are high current passing regions. By setting the three conductive members to be respectively electrically connected to the input gasket, the output gasket, and the ground gasket, high current regions of the MOSFET chip are interconnected with the circuit board through the conductive members. The conductive members not only have a high current carrying capacity, but also can reduce resistance of the interconnection. The MOSFET chip generates less heat, and the conductive members have strong thermal conductivity, so that heat dissipation performance of the MOSFET chip can be effectively improved. In addition, the MOSFET assembly is directly mounted on the carrier chip to form a MOSFET packaging structure. A packaging volume is small, which is conducive to miniaturization of the MOSFET packaging structure.

According to a fourth aspect, this application provides an electronic device, including a housing and the circuit board assembly as described above, and the circuit board assembly is disposed in the housing.

The electronic device provided by this application includes the housing and the circuit board assembly disposed in the housing. The circuit board assembly includes a circuit board and a MOSFET packaging structure mounted on the circuit board. In the MOSFET packaging structure, a first surface of a MOSFET chip is mounted in a mounting region of a carrier chip, and a control signal interconnect between the MOSFET chip and the carrier chip is implemented through a first pad on the carrier chip. An interconnect distance between the MOSFET chip and the carrier chip is short and a parasitic inductance is small, making it easy to implement high-frequency driving. In addition, a MOSFET assembly is formed by mounting conductive members on a second surface of the MOSFET chip. An input gasket, an output gasket, and a ground gasket on the MOSFET chip are high current passing regions. By setting three conductive members to be respectively electrically connected to the input gasket, the output gasket, and the ground gasket, high current regions of the MOSFET chip are interconnected with the circuit board through the conductive members. The conductive members not only have a high current carrying capacity, but also can reduce resistance of the interconnection. The MOSFET chip generates less heat, and the conductive members have strong thermal conductivity, so that heat dissipation performance of the MOSFET chip can be effectively improved. In addition, the MOSFET assembly is directly mounted on the carrier chip to form a MOSFET packaging structure. A packaging volume is small, which is conducive to miniaturization of the MOSFET packaging structure.

### BRIEF DESCRIPTION OF DRAWINGS

FIG. 1 is a schematic diagram of a structure of an electronic device according to an embodiment of this application;
FIG. 2 is a top view of a circuit board assembly according to an embodiment of this application;
FIG. 3 is a schematic diagram of a packaging structure of a GaN MOSFET in a related technology;
FIG. 4 is a schematic cross-sectional view along A-A in FIG. 2;
FIG. 5 is a schematic cross-sectional view of a MOSFET packaging structure in FIG. 4;
FIG. 6 is a planar view of a MOSFET packaging structure according to an embodiment of this application;
FIG. 7 is a circuit diagram of a MOSFET packaging structure according to an embodiment of this application;
FIG. 8A is a schematic cross-sectional view along B-B in FIG. 6;
FIG. 8B is a schematic cross-sectional view along C-C in FIG. 6;
FIG. 9A is another schematic cross-sectional view along B-B in FIG. 6;
FIG. 9B is another schematic cross-sectional view along C-C in FIG. 6;
FIG. 10 is a flowchart of steps of a manufacturing method of a MOSFET packaging structure according to an embodiment of this application;
FIG. 11 is a schematic diagram of manufacturing a MOSFET assembly according to an embodiment of this application;
FIG. 12 is a schematic diagram of forming a dielectric layer and a wiring layer on a wafer according to an embodiment of this application; and
FIG. 13 is a schematic diagram of forming a MOSFET packaging structure according to an embodiment of this application.

### DESCRIPTION OF EMBODIMENTS

Terms used in description of this application are merely intended to explain specific embodiments of this application rather than limit this application.

A MOSFET is a field-effect transistor that uses an electric field effect to control a semiconductor. Because MOSFET can operate under low current and low voltage conditions, and a manufacturing process of the MOSFET facilitates an integrated design, the MOSFET has been widely used in large-scale integrated circuits. For example, the MOSFET can be applied to a power supply of a consumer electronic product, for example, a fast charging power supply for a mobile phone, an adapter, or a personal computer (personal computer, PC) power light. In addition, the MOSFET can also be applied to an industrial power supply (for example, a server power supply, or a communication power supply), an electric vehicle on-board charger, an on-board DC (direct current)-DC converter, or the like.

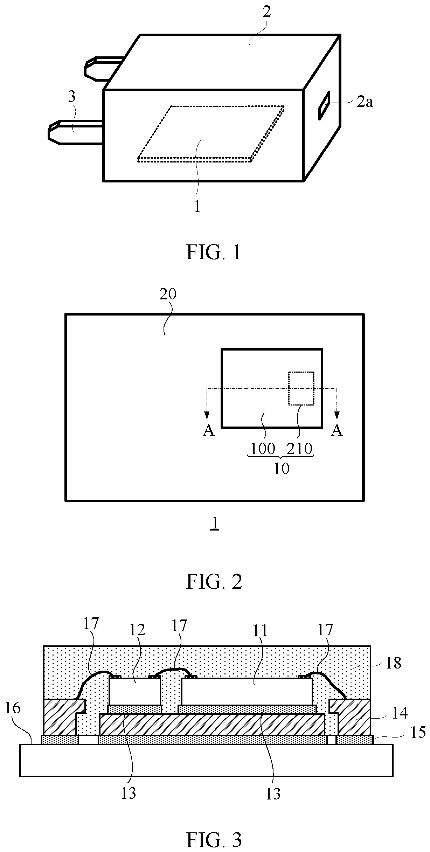

This application provides an electronic device. The electronic device may be the above-mentioned electronic device or another electronic device provided with a MOSFET. FIG. 1 is a schematic diagram of a structure of an electronic device according to an embodiment of this application. Refer to FIG. 1. The electronic device being a mobile phone charger is used as an example. The electronic device may include a housing 2 and a charging plug 3. The housing 2 may be provided with a connecting cable receptacle 2a. The charging plug 3 and the connecting cable receptacle 2a may be respectively located on two opposite sides of the housing 2. During operation, the charging plug 3 of the mobile phone charger is plugged into an external power supply (for example, a socket). One end of a data cable adapted to a mobile phone is connected to the connecting cable receptacle 2a of the mobile phone charger, and the other end of the data cable is connected to the mobile phone to charge the mobile phone.

Still refer to FIG. 1. A circuit board assembly 1 is further provided in the housing 2. The circuit board assembly 1 is configured to acquire a current from the external power supply, and then transmit the current to an electrical device (for example, a battery of the mobile phone). The circuit board assembly 1 includes a circuit board (not shown in the figure) and a MOSFET packaging structure (not shown in the figure). The circuit board is, for example, a printed circuit board (Printed Circuit Board, PCB). The MOSFET packaging structure is connected to the circuit board through a conductive material to implement fastening of the MOSFET packaging structure and an electrical connection between the MOSFET packaging structure and the circuit board. For example, for the circuit board assembly 1 used in the power supply, the MOSFET packaging structure is mainly used as a switch in the circuit board assembly 1, and serves as a bridge to transmit the current from the external power supply to the electrical device through the circuit board.

FIG. 2 is a top view of a circuit board assembly according to an embodiment of this application. Refer to FIG. 2. The MOSFET packaging structure 10 includes a carrier chip 100 and a MOSFET chip 210. The MOSFET chip 210 is mainly used as a switch. The carrier chip 100 is used to provide a charging current to the MOSFET chip 210 when driving the MOSFET chip 210 to be turned on, to ensure that the MOSFET chip 210 can be quickly turned on, and make a voltage of the MOSFET chip 210 remain stable during a turn-on period, to ensure that the MOSFET chip 210 is reliably turned on. For example, the carrier chip 100 may use a silicon chip, and the MOSFET chip 210 is packaged on the silicon chip to form the MOSFET packaging structure 10. The MOSFET packaging structure 10 is installed on the circuit board 20 to form the circuit board assembly 1.

Currently, wide-bandgap semiconductor devices represented by GaN are called third-generation semiconductor devices. A GaN material, with advantages of a large bandgap width, high electron mobility, and a strong breakdown electric field, can be used in a high temperature operation environment, a high pressure operation environment, a high frequency operation environment, and the like, and has a wide range of applications. A GaN MOSFET has been widely used in the field of small and medium-power adapters (for example, mobile phone chargers). Compared with a conventional Si MOSFET, the GaN MOSFET has lower on-resistance (on-resistance between a source and a drain) and a faster switching speed, which can reduce an area of peripheral components (such as an inductor and a capacitor) and reduce a volume of the MOSFET packaging structure 10. Further, the GaN MOSFET can effectively reduce a switching loss, and improve power efficiency.

The conventional Si MOSFET can be directly integrated on the carrier chip 100 because a base material of the Si MOSFET is the same as that of the silicon chip. During packaging of the MOSFET chip 210, that is, during forming of the MOSFET packaging structure 10, the GaN MOSFET is currently usually a packaged as a discrete component and is driven by a separate driver. In other words, the GaN MOSFET and the driver are separately packaged on the circuit board, and then are electrically connected.

To facilitate packaging of the GaN MOSFET, a solution in which the GaN MOSFET and the driver are packaged together has been proposed. FIG. 3 is a schematic diagram of a packaging structure of a GaN MOSFET in a related technology. Refer to FIG. 3. Currently, a GaN MOSFET 12 and a silicon chip 11 are usually pasted to a lead frame 14 through a packaging glue 13, and the lead frame 14 is welded onto a circuit board 16 through a solder 15. There is a specific distance between the GaN MOSFET 12 and the silicon chip 11. Both the GaN MOSFET 12 and the silicon chip 11 are connected to the lead frame 14 through a connecting wire 17 (a bonding wire, or a lead). There are a large quantity of connecting wires 17 connecting the GaN MOSFET 12 and the silicon chip 11, to implement an electrical connection between the GaN MOSFET 12 and the silicon chip 11. The lead frame 14 is usually further covered with a plastic-packaged layer 18. The plastic-packaged layer 18 wraps the GaN MOSFET 12, the silicon chip 11, and the connecting wires 17 that connect the GaN MOSFET 12, the silicon chip 11, and the lead frame 14, to form protection for a packaging structure of GaN MOSFET 12.

However, the connection wires 17 between the GaN MOSFET 12, the silicon chip 11, and the lead frame 14 may introduce a large amount of parasitic inductances, which will cause a switching loss problem or the like and affect a driving frequency of the packaging structure. In addition, the manner of packaging the connecting wires 17 and the lead frame 14 together makes a volume of the packaging structure large, which is not conducive to miniaturization of the packaging structure.

As shown in FIG. 3, an overall thickness of the packaging structure is a thickness of the lead frame 14 plus a thickness of the plastic-packaged layer 18. Surfaces on sides of the GaN MOSFET 12 and the silicon chip 11 facing away from the circuit board 16 are electrode surfaces (a surface that draws out a current) of the GaN MOSFET 12 and the silicon chip 11. The connecting wire 17 is connected to the surfaces on the sides of the GaN MOSFET 12 and the silicon chip 11 facing away from the circuit board 16. An arc height of the connecting wire 17 (a distance between a curved top of the connecting wire 17 and the lead frame 14) is greater than each of a thickness of the GaN MOSFET 12 and a thickness of the silicon chip 11. Because the plastic-packaged layer 18 needs to completely cover the GaN MOSFET 12, the silicon chip 11, and the connecting wires 17, and in order for a sufficient protective effect of the plastic-packaged layer 18, the thickness of the plastic-packaged layer 18 needs to cover at least a thickness of 100 µm above the curved top of the connecting wires 17. Side-by-side installation of the GaN MOSFET 12 and the silicon chip 11 on the lead frame 14 causes a large planar area occupied by the packaging structure. In addition, due to a limitation of the arc height of the connecting wire 17, the thickness of the plastic-packaged layer 18 is thick, causing an overall thickness of the packaging structure to be large. As a result, the volume of the packaging structure is large.

In addition, for the GaN MOSFET 12 with a high current carrying capacity requirement, the packaging structure needs to have better heat dissipation performance. In the solution in which the packaging the connecting wires 17 and the lead frame 14 are packaged together, heat generated by the GaN MOSFET 12 is mainly transferred to the lead frame 14 at the bottom, and is then transferred to the circuit board 16 through the lead frame 14 and the solder 15 for heat dissipation. The remaining parts of the GaN MOSFET 12 are wrapped by the plastic-packaged layer 18. Limited by a material and its thickness, the plastic-packaged layer 18 has poor heat dissipation performance. As a result, the heat of the GaN MOSFET 12 cannot be dissipated to the outside through the plastic-packaged layer 18 in a timely and effective manner.

In view of this, in a circuit board assembly 1 of this embodiment, a conductive member is attached to one side of the MOSFET chip 210, and the conductive member and the MOSFET chip 210 jointly constitute a MOSFET assembly. A surface of a side that is of the MOSFET chip 210 and that is exposed outside the conductive member is mounted on a mounting surface of the carrier chip 100 to form a MOSFET packaging structure 10. The MOSFET packaging structure 10 has a small volume, which is conducive to the miniaturization of the packaging structure. In addition, the MOSFET chip 210 is mounted on the carrier chip 100, so that a signal interconnect with a low parasitic inductance can be achieved between the MOSFET chip 210 and the carrier chip 100, and between the MOSFET chip 210, the carrier chip 100, and a circuit board 20, and a switching loss or another problem is not caused. This facilitates implementation of high-frequency driving, has small thermal resistance and good heat dissipation performance, and can improve performance of the MOSFET packaging structure 10.

The circuit board assembly 1 of this embodiment will be described in detail below.

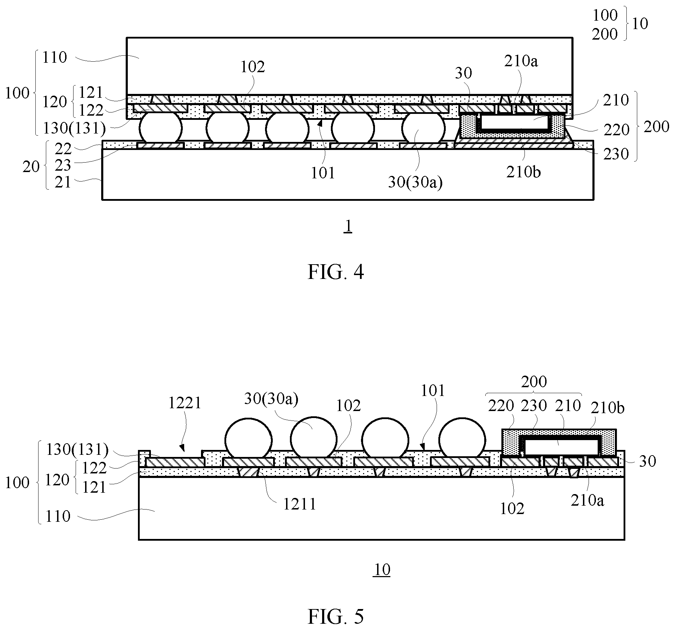

FIG. 4 is a schematic cross-sectional view along A-A in FIG. 2. Refer to FIG. 4. A surface on one side of a carrier chip 100 is a mounting surface 101, and a plurality of first pads 102 are distributed on the mounting surface 101. AMOSFET chip 210 is mounted on the mounting surface 101 of the carrier chip 100 to form a MOSFET packaging structure 10. The MOSFET chip 210 is connected to a corresponding first pad 102 on the mounting surface 101 of the carrier chip 100 to implement a fixed connection and an electrical connection between the MOSFET chip 210 and the carrier chip 100.

When the MOSFET packaging structure 10 is installed on the circuit board 20, the mounting surface 101 of the carrier chip 100 faces the circuit board 20, and the MOSFET packaging structure 10 is mounted face-to-face on the circuit board 20 to form a circuit board assembly 1. A plurality of second pads 23 are distributed on a surface of the circuit board 20. The MOSFET chip 210 mounted on the mounting surface 101 of the carrier chip 100 is opposite to the circuit board 20. The MOSFET chip 210 is connected to the corresponding second pad 23 on the circuit board 20 through a conductive material 30 to implement an electrical connection between the MOSFET chip 210 and the circuit board 20. For another region of the mounting surface 101 of the carrier chip 100, the first pad 102 on the carrier chip 100 and the second pad 23 on the circuit board 20 are opposite to each other. A conductive material 30 is provided between the first pad 102 and the second pad 23. The first pad 102 on the carrier chip 100 and the second pad 23 on the circuit board 20 are connected through the conductive material 30 to achieve a fixed connection and an electrical connection between the carrier chip 100 and the circuit board 20.

For example, the conductive material 30 between the MOSFET chip 210 and the second pad 23 and the conductive material 30 between the first pad 102 and the second pad 23 may be Sn or SnAg.

During operation, the circuit board 20 transmits a control signal to the carrier chip 100, and then the carrier chip 100 drives the MOSFET chip 210 to be turned on, provides a charging current to the MOSFET chip 210, and keeps a voltage of the MOSFET chip 210 stable during a turn-on period. When the MOSFET chip 210 is turned on, a main high-current signal is transmitted from the circuit board 20 to the MOSFET chip 210. In addition, a driving signal is transmitted between the MOSFET chip 210 and the carrier chip 100, and between the MOSFET chip 210 and the circuit board 20.

For example, the MOSFET chip 210 may be the foregoing GaN MOSFET, or the MOSFET chip 210 may alternatively be another chip that needs to be packaged with the carrier chip 100. The carrier chip 100 may be the foregoing silicon chip, or the carrier chip 100 may alternatively be another chip that can provide a driving signal for the MOSFET chip 210. This is not specifically limited in this embodiment.

In addition, refer to FIG. 4. It should be noted that the carrier chip 100 includes a chip body 110 and a wiring structure provided on a surface of the chip body 110. The carrier chip 100 being a silicon chip is used as an example. The chip body 110 may be made of monocrystalline silicon. The chip body 110 is provided with a conductive structure (not shown in the figure). For example, the conductive structure may be a component such as a transistor or a diode provided in the chip body 110. Alternatively, the conductive structure may be an interconnect structure such as conductive pillars or conductive wires provided in the chip body 110, and the conductive structure is exposed on the surface of the chip body 110.

The wiring structure includes a dielectric layer 120 disposed on the surface of the chip body 110 and a wiring layer 130 provided in the dielectric layer 120. The dielectric layer 120 can protect the wiring layer 130. The wiring layer 130 is configured to connect to the conductive structure in the chip body 110. A side of the dielectric layer 120 facing away from the chip body 110 has an opening 1221. A partial region of conductive wires 131 is exposed in the opening 1221 of the dielectric layer 120. The exposed region of the conductive wires 131 is used to connect to the MOSFET chip 210 and the circuit board 20. The first pad 102 is an exposed region of the conductive wires 131; or the first pad 102 is a pad added in the exposed region of the conductive wires 131. An area of the added pad may be greater than an area of the exposed region of the conductive wires 131 to increase connection strength between the carrier chip 100, the MOSFET chip 210, and the circuit board 20 through the first pad 102, and enhance stability of electrical connection between the carrier chip 100, the MOSFET chip 210, and the circuit board 20.

FIG. 5 is a schematic cross-sectional view of a MOSFET packaging structure in FIG. 4. Refer to FIG. 5. The insulating dielectric layer 120 provided on the chip body 110 has two layers. The dielectric layer 120 includes a first dielectric layer 121 and a second dielectric layer 122 that are successively stacked on the chip body 110. The wiring layer 130 is provided on the first dielectric layer 121. Through holes (not shown in the figure) are provided in the first dielectric layer 121. The various conductive wires 131 in the wiring layer 130 pass through the through holes and are connected to the conductive structure in the chip body 110. The second dielectric layer 122 covers the wiring layer 130 to protect the conductive wires 131 in the wiring layer 130 and insulate the conductive wires 131 from the outside. The second dielectric layer 122 is provided with the opening 1221. A partial region of the conductive wires 131 is exposed at the opening 1221 for connection to a conductive material 30 to implement the connection between the carrier chip 100, the MOSFET chip 210, and the circuit board 20.

Similar to the carrier chip 100, the circuit board 20 may include a substrate 21 and a wiring layer (not shown in the figure) provided on the substrate 21. The wiring layer is a plurality of conductive wires formed on the substrate 21 (not shown in the figure). The wiring layer is usually covered with an insulation protection layer 22, and the protection layer 22 has an opening. A partial region of the conductive wires is exposed in the opening in the protection layer 22. The second pad 23 is an exposed region of the conductive wires, or the second pad 23 is a pad added in the exposed region of the conductive wires, which is not described herein again.

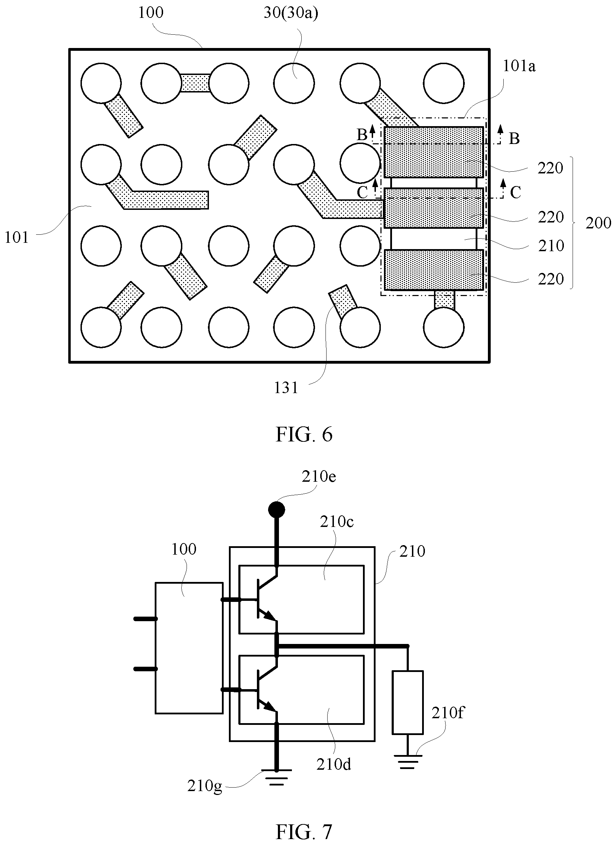

FIG. 6 is a planar view of a MOSFET packaging structure according to an embodiment of this application. Refer to FIG. 6. The mounting surface 101 of the carrier chip 100 has a mounting region 101a. The mounting region 101a is used to mount the MOSFET chip 210. In this embodiment, surfaces on two sides opposite to each other in a thickness direction of the MOSFET chip 210 are respectively defined as a first surface 210a and a second surface 210b. The first surface 210a of the MOSFET chip 210 is mounted in the mounting region 101a. A corresponding region of the first surface 210a of the MOSFET chip 210 is connected to a first pad 102 in the mounting region 101a. The second surface 210b of the MOSFET chip 210 is used to electrically connect to the circuit board 20.

The first pad 102 in the mounting region 101a can be electrically connected to a first pad 102 outside the mounting region 101a through the conductive wires 131. The first pad 102 outside the mounting region 101a is connected to a corresponding second pad 23 on the circuit board 20. In this way, the circuit board 20 transmits the control signal to the corresponding first pad 102 outside the mounting region 101a on the carrier chip 100 through the second pad 23. The carrier chip 100 receives the control signal. The control signal is transmitted to the corresponding first pad 102 inside the mounting region 101a through the first pad 102 outside the mounting region 101a by using the conductive wires 131, to drive the MOSFET chip 210 to be turned on.

As shown in FIG. 5 and FIG. 6, when the MOSFET chip 210 is interconnected with the circuit board 20, to enable a high current to pass between the MOSFET chip 210 and the circuit board 20, in this embodiment, the second surface 210b of the MOSFET chip 210 is further mounted with a conductive member 220. The conductive member 220 faces the circuit board 20 and is connected to the circuit board 20. For example, the conductive member 220 may be made of a metal material with high electrical conductivity such as copper, aluminum, titanium, gold, or silver. In this way, a current carrying capacity of the MOSFET chip 210 can be improved through the conductive member 220, so that the MOSFET chip 210 implements a high current carrying effect.

When the MOSFET chip 210 operates, there is a high-current region. A current flowing through the high-current region is high. In view of this, the conductive member 220 is usually disposed corresponding to the high-current region to improve a current carrying capacity of the high-current region of the MOSFET chip 210, so as to implement high-frequency driving of the MOSFET chip 210. Because a current flowing through another region, of the MOSFET chip 210, used to transmit a driving signal is quite low, the another region on the second surface 210b of the MOSFET chip 210 can be directly connected to the circuit board 20 through the conductive material 30.

As shown in FIG. 4 and FIG. 6, compared with the second surface 210b of the MOSFET chip 210 being directly connected to the circuit board 20 through the conductive material 30 such as Sn or SnAg, the second surface 210b of the MOSFET chip 210 is mounted with the conductive member 220 as described above. Electrical conductivity of the conductive member 220 is much higher than that of the conductive material 30 such as Sn or SnAg. The material of the conductive member 220 being Cu is used as an example. Electrical conductivity of Cu is 7.4 times that of SnAg. Therefore, the conductive member 220 has a high current carrying capacity, and a contact area between the conductive member 220 and the circuit board 20 is large, which can implement the high current carrying effect of the MOSFET chip 210.

In addition, compared with the conductive materials 30 such as Sn or SnAg, the conductive member 220 has higher thermal conductivity. The material of the conductive member 220 being Cu is still used as an example. Thermal conductivity of Cu is 7 times that of SnAg. Therefore, the conductive member 220 not only has the high current carrying capacity, but also can dissipate heat generated by the MOSFET chip 210 to the outside in a timely and efficient manner. In this embodiment, compared with the interconnection between the high-current region of the MOSFET chip 210 and the circuit board 20 by using the connecting wires or the conductive material 30 such as Sn and SnAg, the interconnection between the high-current region of the MOSFET chip 210 and the circuit board 20 by using the conductive member 220 has lower interconnection resistance, and enables the MOSFET chip 210 to generate less heat. In addition, the conductive member 220 has strong thermal conductivity, so the heat dissipation performance of the MOSFET chip 210 can be effectively improved.

Refer to FIG. 4 and FIG. 6. In this embodiment, the first surface 210a of the MOSFET chip 210 is mounted in the mounting region 101a of the carrier chip 100, and a control signal interconnect between the MOSFET chip 210 and the carrier chip 100 is implemented through the first pad 102 on the carrier chip 100. In addition, a MOSFET assembly 200 is formed by mounting the conductive member 220 on the second surface 210b of the MOSFET chip 210. When the MOSFET packaging structure 10 is packaged on the circuit board 20, the high current region of the MOSFET chip 210 is interconnected with the circuit board 20 through the conductive member 220. Another region of the MOSFET chip 210 and the circuit board 20, and the carrier chip 100 and the circuit board 20 are interconnected through the conductive material 30. An interconnect distance between any two of the MOSFET chip 210, the carrier chip 100, and the circuit board 20 is short and a parasitic inductance is small, making it easy to implement high-frequency driving.

Moreover, since the MOSFET chip 210 is mounted face-to-face on the carrier chip 100, when the MOSFET packaging structure 10 is interconnected with the circuit board 20, the MOSFET assembly 200 does not occupy additional space. Space occupied by the MOSFET packaging structure 10 is equivalent to space occupied by the carrier chip 100. A small volume of the MOSFET packaging structure 10 is beneficial to the MOSFET packaging structure 10, enabling the MOSFET packaging structure 10 to be applied in an ultra-thin electronic device. Specifically, when the carrier chip 100 is interconnected with the circuit board 20, the first pad 102 on the carrier chip 100 and the second pad 23 on the circuit board 20 may be connected through a solder ball 30a. Thickness space of the MOSFET assembly 200 may be less than thickness space occupied by the solder ball 30a after being packaged. There is a gap between the conductive member 220 mounted on the second surface 210b of the MOSFET chip 210 and the circuit board 20. The conductive member 220 may be connected to the circuit board 20 through the thin conductive material 30. The MOSFET assembly 200 does not affect normal packaging space of the carrier chip 100.

For example, an initial diameter of the solder ball 30a connected between the first pad 102 on the carrier chip 100 and the second pad 23 on the circuit board 20 may be 300 µm. After soldering, a height of the solder ball 30a is reduced to 200 µm. A thickness of the MOSFET chip 210 is, for example, 60 µm, a thickness of the conductive member 220 is, for example, 100 µm, and there may be, for example, connection space of 10 µm between the conductive member 220 and the second surface 210b of the MOSFET chip 210. In this way, there is still a 30-µm gap between the conductive member 220 and the circuit board 20. The gap may be used to place the conductive material 30 to implement the electrical connection between the MOSFET chip 210 and the circuit board 20.

The MOSFET packaging structure 10 being mounted on the circuit board 20 ensures that an interconnect distance between the MOSFET packaging structure 10 and the circuit board 20 is short and a parasitic inductance is small. Further, the conductive member 220 implements characteristics of high current carrying and low thermal resistance when the MOSFET chip 210 and the circuit board 20 are interconnected. This can improve the current carrying capacity of the MOSFET chip 210, ensure heat dissipation performance of the MOSFET chip 210, and thus improve operation performance of the MOSFET chip 210.

FIG. 7 is a circuit diagram of the MOSFET packaging structure 10 according to an embodiment of this application. As shown in FIG. 7, for the MOSFET chip 210 applied in the power supply field, the carrier chip 100 usually drives a half-bridge circuit. In this case, the MOSFET chip 210 usually includes two transistors in a half-bridge arrangement. For example, the MOSFET chip 210 includes a first transistor 210c and a second transistor 210d that share a source. A drain of the first transistor 210c is connected to an external power supply as an input terminal 210e. A drain of the second transistor 210d is a ground terminal 210g. The source terminal shared by the first transistor 210c and the second transistor 210d is connected to an output load as an output terminal 210f.

During operation, when an external control signal is high, the carrier chip 100 controls the first transistor 210c to be turned on and the second transistor 210d to be turned off. A current from the external power supply enters the first transistor 210c from the drain of the first transistor 210c and is transmitted to the output load through the first transistor 210c. When the external control signal is low, the carrier chip 100 controls the second transistor 210d to be turned on and the first transistor 210c to be turned off. The grounded second transistor 210d extracts charge from the output load to achieve grounding and can withstand a high voltage.

In other words, the MOSFET chip 210 includes the input terminal 210e, the output terminal 210f, and the ground terminal 210g. The input terminal 210e, the output terminal 210f, and the ground terminal 210g of the MOSFET chip 210 are all connected to the outside through the circuit board 20. These three parts are high-current regions when the MOSFET chip 210 is interconnected with the circuit board 20. In view this, as shown in FIG. 6, the MOSFET chip 210 is provided with an input gasket (not shown in the figure), an output gasket (not shown in the figure), and a ground gasket (not shown in the figure) at corresponding positions of the input terminal 210e, the output terminal 210f, and the ground terminal 210g of the MOSFET chip 210 respectively. The input gasket, the output gasket, and the ground gasket of the MOSFET chip 210 are used to be electrically connected to the circuit board 20.

There may be three conductive members 220 mounted on the second surface 210b of the MOSFET chip 210. The three conductive members 220 are electrically connected to the input gasket, the output gasket, and the ground gasket respectively. The first conductive member 220 is connected between the input gasket and a corresponding second pad 23 on the circuit board 20, the second conductive member 220 is connected between the output gasket and a corresponding second pad 23 on the circuit board 20, and the third conductive member 220 is connected between the ground gasket and a corresponding second pad 23 on the circuit board 20. The three conductive members 220 are arranged at intervals to implement electrical isolation between the input gasket, the output gasket, and the ground gasket. The three conductive members 220 are used to implement a high current carrying capacity of the input terminal 210e, the output terminal 210f, and the ground terminal 210g of the MOSFET chip 210.

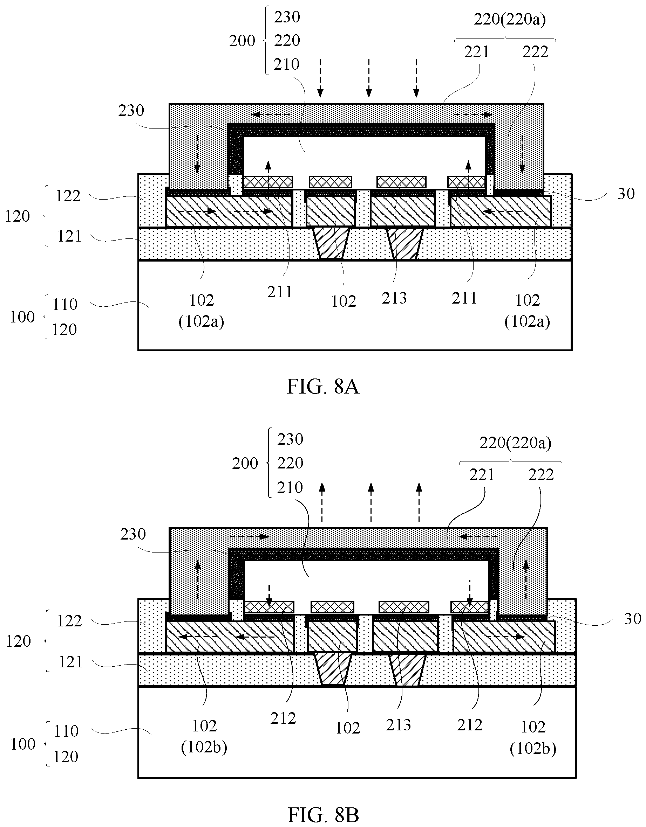

FIG. 8A is a schematic cross-sectional view along B-B in FIG. 6. FIG. 8B is a schematic cross-sectional view along C-C in FIG. 6. Refer to FIG. 8A or FIG. 8B. A plurality of conductive gaskets 213 are provided on the MOSFET chip 210. The conductive gaskets 213 are used to electrically connect to the first pad 102 on the carrier chip 100, so as to transmit a driving signal between the carrier chip 100 and the MOSFET chip 210. In order to facilitate electrical connections between the conductive gaskets 213 on the MOSFET chip 210 and the first pads 102 on the carrier chip 100, the conductive gaskets 213 are usually distributed on the first surface 210a of the MOSFET chip 210. The conductive gaskets 213 are in a one-to-one correspondence with the first pads 102 on the carrier chip 100. The conductive gaskets 213 on the MOSFET chip 210 are connected to the first pads 102 on the carrier chip 100 through the conductive materials 30.

In this way, for the MOSFET chip 210 mounted face-to-face on the mounting surface 101 of the carrier chip 100, the conductive gaskets 213 provided on the first surface 210a of the MOSFET chip 210 are directly opposite to the first pads 102 on the carrier chip 100. In this way, an interconnect distance of a driving signal between the MOSFET chip 210 and the carrier chip 100 is short, a parasitic inductance is small, and high-frequency driving is easy to be implemented.

For the arrangement of the input gasket 211, the output gasket 212, and the ground gasket on the MOSFET chip 210, in an implementation, the input gasket 211, the output gasket 212, and the ground gasket on the MOSFET chip 210 may all be located at a side at which the first surface 210a of the MOSFET chip 210 is located. In this way, the input gasket 211, the output gasket 212, and the ground gasket are arranged on the first surface 210a on the same side as the conductive gaskets 213 used to transmit the driving signal. This is equivalent to that an active surface of the MOSFET chip 210 is the first surface 210a, which facilitates transmission of the driving signal to the active surface of the MOSFET chip 210 through the conductive gaskets 213.

In this case, high-current transmission between the MOSFET chip 210 and the circuit board 20 needs to pass through the first surface 210a of the MOSFET chip 210. Because the first surface 210a of the MOSFET chip 210 is attached to the mounting surface 101 of the carrier chip 100, the mounting surface 101 of the carrier chip 100 has to be provided with first pads 102 corresponding to the input gasket 211, the output gasket 212, and the ground gasket on the first surface 210a of the MOSFET chip 210. In this embodiment, the first pads 102 on the carrier chip 100 that are corresponding to the input gasket 211, the output gasket 212, and the ground gasket are defined as an input pad 102a, an output pad 102b, and a ground pad respectively. The input pad 102a and the input gasket 211, the output pad 102b and the output gasket 212, and the ground pad and the ground gasket are all connected through the conductive materials 30.

A large current needs to pass through the conductive member 220 and the first pads 102 on the carrier chip 100 when transmitted between the MOSFET chip 210 and the circuit board 20. Therefore, the conductive member 220 needs to be connected to the first pads 102 on the carrier chip 100. Refer to FIG. 8A or FIG. 8B. The conductive member 220 may be provided in a form of a conductive frame 220a. The conductive frame 220a surrounds an outer circumference of the MOSFET chip 210. Both ends of the conductive frame 220a are connected to the first pads 102 on the carrier chip 100 through the conductive materials 30. In this way, when a current is transmitted between the MOSFET chip 210 and the circuit board 20, the current may be transmitted between the conductive frame 220a, the first pads 102, and corresponding parts of the carrier chip 100 that are connected successively.

The conductive frame 220a may include a main plate portion 221 and side plate portions 222. The main plate portion 221 correspondingly covers the second surface 210b of the MOSFET chip 210. The side plate portions 222 are connected to two opposite sides of the main plate portion 221. The side plate portions 222 each extend along a side wall surface of the MOSFET chip 210. One end of each of the side plate portions 222 is connected to a side edge of the main plate portion 221, and the other end of the side plate portion 222 extends and is connected to the first pad 102 on the carrier chip 100. In this way, the conductive frame 220a forms a structure surrounding the second surface 210b and the side wall surface of the MOSFET chip 210. The main plate portion 221 of the conductive frame 220a is used to connect to the second surface 210b of the MOSFET chip 210. The side plate portions 222 of the conductive frame 220a are used to connect to the first pads 102 on the carrier chip 100. The input gasket 211, the output gasket 212, and the ground gasket on the first surface 210a of the MOSFET chip 210 are connected to the corresponding conductive frame 220a through the corresponding first pads 102, which implements transmission of a high current between the circuit board 20 and the MOSFET chip 210.

The conductive frame 220a is an independent structural member, and the MOSFET chip 210 may be mounted on the conductive frame 220a. Specifically, as shown in FIG. 8A or FIG. 8B, an adhesive layer 230 may be provided between the conductive frame 220a and the MOSFET chip 210. The MOSFET chip 210 is attached to the conductive frame 220a through the adhesive layer 230. The adhesive layer 230 may cover only the second surface 210b of the MOSFET chip 210, or the adhesive layer 230 may also extend to cover the side wall surface of the MOSFET chip 210 to ensure that the MOSFET chip 210 is firmly connected to the conductive frame 220a. For example, the adhesive layer 230 may be made of silver paste, sintered silver, CuSn or AuSn, or the like.

During assembly of the MOSFET assembly 200, the inner wall surface of the conductive frame 220a may be first coated with one adhesive layer 230, then the MOSFET chip 210 is placed into the conductive frame 220a, and a surface of the MOSFET chip 210 is connected and fastened to the adhesive layer 230. In this way, the MOSFET chip 210 is mounted on the conductive frame 220a.

For example, the conductive frame 220a may be a copper frame or a copper alloy frame. As mentioned above, compared with the conductive material 30 connected between the first pad 102 on the carrier chip 100 and the second pad 23 on the circuit board 20, copper and copper alloy have much higher electrical conductivity and thermal conductivity. Using the copper frame as the conductive frame 220a not only can achieve a high current carrying capacity of the conductive member 220, but also can efficiently dissipate heat generated by the MOSFET chip 210 to the outside, which can improve performance of the MOSFET packaging structure 10.

For illustration of transmission of a high current between the circuit board 20 and the carrier chip 100, FIG. 8A is used as an example, which shows a cross-sectional view of a region in which input gaskets 211 on the MOSFET chip 210 are located. Refer to dashed arrows in the figure, and refer to FIG. 4. A current on the circuit board 20 flows into the input gaskets 211 on the MOSFET chip 210 through the conductive frame 220a. The current flows from the circuit board 20, passes through the main plate portion 221 and the side plate portions 222 of the conductive frame 220a successively, enters the input pads 102a on the carrier chip 100, and then flows from the input pads 102a to the input gaskets 211 on the MOSFET chip 210, so that a high current enters the MOSFET chip 210 from the circuit board 20. FIG. 8B is used as an example, which shows a cross-sectional view of a region in which the output gaskets 212 on the MOSFET chip 210 are located. Refer to dashed arrow in the figure, and refer to FIG. 4. A current on the MOSFET chip 210 flows into the circuit board 20 from the output gaskets 212 after passing through the conductive frame 220a. The current flows from the output gaskets 212 on the MOSFET chip 210 to the output pads 102b on the carrier chip 100, then enters the conductive frame 220a from the output pads 102b, and flows into the circuit board 20 after passing through the side plate portions 222 and the main plate portion 221 of the conductive frame 220a successively, so that a high current flows out from the output gaskets 212 on the MOSFET chip 210 to the circuit board 20.

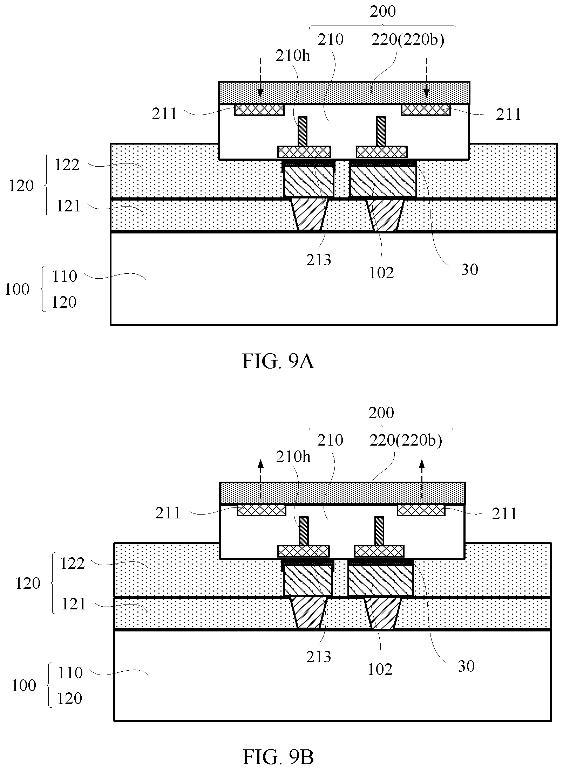

FIG. 9A is another schematic cross-sectional view along B-B in FIG. 6. FIG. 9B is another schematic cross-sectional view along C-C in FIG. 6. Refer to FIG. 9A or FIG. 9B. In another implementation, the input gasket 211, the output gasket 212, and the ground gasket on the MOSFET chip 210 may all be located on a side at which the second surface 210b of the MOSFET chip 210 is located. This is equivalent to that the active surface of the MOSFET chip 210 is the second surface 210b of the MOSFET chip 210. The active surface is located on a side opposite to a side of the conductive gaskets 213 used to transmit a driving signal. In this case, to enable the driving signal to be transmitted to the active surface, via holes 210h may be provided in the MOSFET chip 210. The via holes 210h each extend from the first surface 210a of the MOSFET chip 210 to the second surface 210b. Two ends of the via hole 210h respectively extend to the conductive gasket 213 provided on the first surface 210a and an electrode (for example, a gate, which is not shown in the figure) of a transistor (for example, the foregoing first transistor 210c or the second transistor 210d) provided on a side close to the second surface 210b. The via hole 210h is filled with a conductive material to electrically connect the conductive gasket 213 to the electrode through the conductive material, so that a driving signal of the carrier chip 100 can be transmitted to the electrode to turn on the transistor of MOSFET chip 210.

For a case that the input gasket 211, the output gasket 212, and the ground gasket are all provided on the second surface 210b of the MOSFET chip 210, the three conductive members 220 mounted on the second surface 210b of the MOSFET chip 210 can respectively cover the input gasket 211, the output gasket 212, and the ground gasket, to implement connection of each the input gasket 211, the output gasket 212, and the ground gasket to the corresponding conductive member 220.

Because each of the input gasket 211, the output gasket 212, and the ground gasket is directly attached to the corresponding conductive member 220, there is no need to provide the corresponding first pads 102 on the mounting surface 101 of the carrier chip 100 to connect the input gasket 211, the output gasket 212, and the ground gasket to the conductive members 220. Therefore, the conductive member 220 does not need to be designed as a frame structure that needs to extend to be connected to the first pad 102 on the carrier chip 100. Refer to FIG. 9A or FIG. 9B. In this case, the conductive member 220 may be a conductive layer 220b covering the second surface 210b of the MOSFET chip 210. The conductive layer 220b is a metal layer. For example, the conductive layer 220b may be a copper layer or an aluminum layer, to ensure that the conductive layer 220b has high electrical conductivity and thermal conductivity. The conductive layer 220b not only can achieve the high current carrying capacity of the conductive member 220, but also can efficiently dissipate heat generated by the MOSFET chip 210 to the outside, which can improve performance of the MOSFET packaging structure 10.

The conductive layer 220b may be directly deposited on the second surface 210b of the MOSFET chip 210 through a process such as chemical vapor deposition (Chemical Vapor Deposition, CVD) or physical vapor deposition (Physical Vapor Deposition, PVD). Therefore, a connecting medium is not required between the conductive layer 220b and the MOSFET chip 210. Alternatively, the conductive layer 220b may be provided as an independent conductive plate. The conductive plate is, for example, a copper plate or an aluminum plate. The conductive plate may be mounted on the second surface 210b of the MOSFET chip 210 through the foregoing adhesive layer 230. This is not limited in this embodiment.

In addition, the input gasket 211, the output gasket 212, and the ground gasket are directly connected to the corresponding conductive members 220. FIG. 9A is used as an example, which shows a cross-sectional view of the region in which the input gaskets 211 on the MOSFET chip 210 are located. Refer to the dashed arrows in the figure, and refer to FIG. 4. The current on the circuit board 20 flows directly into the input gaskets 211 through the conductive layer 220b, so that a high current enters the MOSFET chip 210 from the circuit board 20. Refer to FIG. 9B. FIG. 9B is used as an example, which shows a cross-sectional view of the region in which the output gaskets 212 on the MOSFET chip 210 are located. Refer to the dashed arrows in the figure, and refer to FIG. 4. The current is directly transmitted from the output gaskets 212 on the MOSFET chip 210 to the conductive layer 220b, and then flows out to the circuit board 20 through the conductive layer 220b, so that a high current flows out from the output gaskets 212 on the MOSFET chip 210 to the circuit board 20.

In some other embodiments, the input gasket 211, the output gasket 212, and the ground gasket on the MOSFET chip 210 may alternatively be provided on opposite sides. In this case, the three conductive members 220 mounted on the MOSFET chip 210 may also have different structures to facilitate connection to the corresponding input gasket 211, output gasket 212, and ground gasket located at different locations. For example, the input gasket 211 and the output gasket 212 are provided on the first surface 210a of the MOSFET chip 210, and the ground gasket is provided on the second surface 210b of the MOSFET chip 210. For this, two conductive members 220 respectively connected to the input gasket 211 and the output gasket 212 may be configured as the conductive frame 220a, and a conductive member 220 connected to the ground gasket may be configured as the conductive layer 220b. Details are not described herein.

An embodiment further provides a manufacturing method of a MOSFET packaging structure (referred to as the manufacturing method below). The manufacturing method is used to manufacture the foregoing MOSFET packaging structure 10. The MOSFET packaging structure 10 may be manufactured by using wafer level chip scale packaging (Wafer Level Chip Scale Packaging, WLCSP for short). To be specific, a MOSFET chip 210 and a conductive member 220 are packaged first to form a MOSFET assembly 200, which is packaged on a wafer with a plurality of carrier chips 100 in an array. Then, the wafer is cut to form separate MOSFET packaging structures 10.

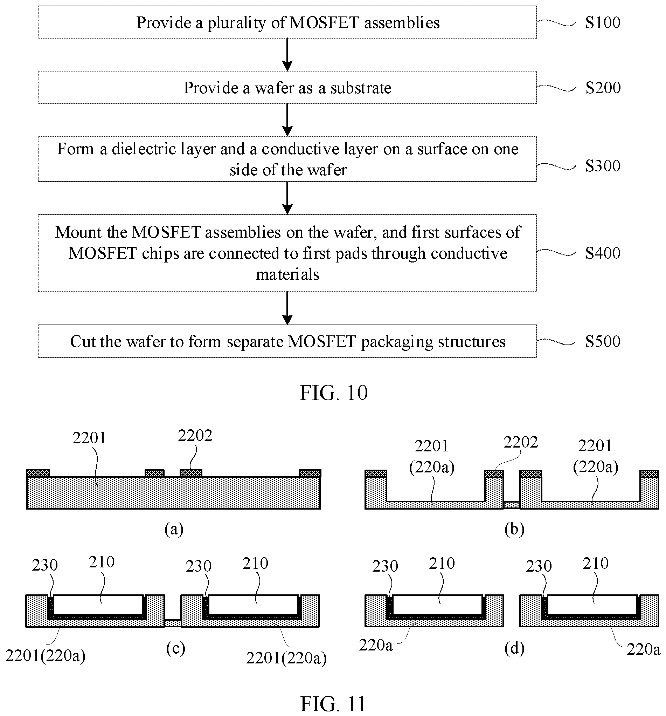

FIG. 10 is a flowchart of steps of a manufacturing method of a MOSFET packaging structure according to an embodiment of this application. Refer to FIG. 10. Specifically, the manufacturing method includes the following steps:
S100: Provide a plurality of MOSFET assemblies.

As shown in FIG. 5 and FIG. 6, first, a plurality of MOSFET assemblies 200 that need to be packaged on a wafer are provided. As mentioned above, the MOSFET assemblies 200 each include a MOSFET chip 210 and three conductive members 220. The conductive members 220 are mounted on the MOSFET chip 210, and the three conductive members 220 are all attached to a second surface 210b of the MOSFET chip 210 and are disposed at intervals.

Refer to FIG. 8A to FIG. 9B. The MOSFET chip 210 has an input gasket 211, an output gasket 212, and a ground gasket. The input gasket 211, the output gasket 212, and the ground gasket may be located on a side on which a first surface 210a of the MOSFET chip 210 is located, or may be located on a side on which a second surface 210b of the MOSFET chip 210 is located. The three gaskets may be provided on the same side or on different sides. Regarding locations of the input gasket 211, the output gasket 212, and the ground gasket, the corresponding conductive members 220 may be configured as a conductive frame 220a or a conductive layer 220b. Details are not described herein again.

Refer to FIG. 8A and FIG. 8B. In an implementation, when the input gasket 211, the output gasket 212, and the ground gasket are all located on the side on which the first surface 210a of the MOSFET chip 210 is located, the conductive frame 220a may be provided as the conductive member 220, to mount the MOSFET chip 210 on the conductive frame 220a. In this case, an integrated structural member with a plurality of conductive frames 220a may be formed first, a plurality of MOSFET chips 210 are mounted on the conductive frames 220a in a one-to-one correspondence, and then the integrated structural member may be cut to form separate MOSFET assemblies 200. In this way, the plurality of MOSFET assemblies 200 can be formed at the same time, that is, the MOSFET assemblies 200 can be manufactured in batches, which improves manufacturing efficiency of MOSFET assemblies 200.

FIG. 11 is a schematic diagram of manufacturing a MOSFET assembly according to an embodiment of this application. As shown in FIG. 11, the assembly manner of simultaneously forming a plurality of MOSFET assemblies 200 by using the conductive frame 220a as the conductive member 220 is specifically as follows:
As shown in FIG. 11(a), a conductive plate 2201 is first provided. As shown in FIG. 11(b), the conductive plate 2201 is then processed to form a plurality of interconnected conductive frames 220a. The figure shows that the conductive plate 2201 is processed into the plurality of interconnected conductive frames 220a through an etching process. Specifically, the conductive plate 2201 is covered with a mask plate 2202, where the mask plate 2202 has a mask pattern, then the conductive plate 2201 is etched according to the mask pattern, and the mask pattern is transferred to the conductive plate 2201 to form the plurality of interconnected conductive frames 220a. In practical application, the conductive plate 2201 may alternatively be processed into the plurality of interconnected conductive frames 220a through another process. For example, the conductive plate 2201 may be stamped and formed into the plurality of interconnected conductive frames 220a through a stamping for molding process.

As shown in FIG. 11(c), after the plurality of interconnected conductive frames 220a are formed, one adhesive layer 230 may be coated on an inner wall surface of each conductive frame 220a. As mentioned above, the conductive frame 220a includes a main plate portion 221 and side plate portions 222. One end of each of the side plate portions 222 is connected to a side edge of the main plate, and the other end of the side plate portion 222 extends toward one side of the main plate portion 221. The inner wall surface of the conductive frame 220a is a surface on one side of the main plate portion 221 facing the side plate portion 222 and a wall surface of the side plate portion 222 connected to the surface one the side of the main plate portion 221. Then, each MOSFET chip 210 is placed correspondingly into each conductive frame 220a, that is, the MOSFET chip 210 is placed in a region enclosed by the main plate portion 221 and the side plate portions 222 of the conductive frame 220a, and the MOSFET chip 210 and the conductive frame 220a are pressed together, so that each MOSFET chip 210 is firmly mounted on each conductive frame 220a.

As shown in FIG. 11(d), after the MOSFET chips 210 are mounted on the interconnected conductive frames 220a, the conductive plate 2201 is cut. Specifically, a connecting part between the conductive frames 220a is cut to form the plurality of independent MOSFET assemblies 200.

It can be understood that after the conductive plate 2201 forms the plurality of interconnected conductive frames 220a, conductive frames 220a corresponding to each MOSFET chip 210 are three conductive frames 220a arranged at intervals, and the three conductive frames 220a are connected together. When the conductive plate 2201 is cut, the conductive frames 220a corresponding to different MOSFET chips 210 are separated, and the three conductive frames 220a of each MOSFET chip 210 are also separated.

As shown in FIG. 9A and FIG. 9B, in another implementation, when the input gasket 211, the output gasket 212, and the ground gasket are all located on the side on which the second surface 210b of the MOSFET chip 210 is located, the conductive layer 220b may be deposited on the second surface 210b of the MOSFET chip 210 as the conductive member 220. In this case, the conductive layer 220b may be deposited on the second surface 210b of each MOSFET chip 210 first, and then each MOSFET chip 210 is mounted on each carrier chip 100 of the wafer; or all the MOSFET chips 210 may be mounted on the wafer first, and then the conductive layer 220b is deposited on the second surface 210b of each MOSFET chip 210.

In the following, the conductive member 220 is used as the conductive frame 220a to describe a subsequent manufacturing process of the MOSFET packaging structure 10.

S200: Provide a wafer, where the wafer includes a plurality of chip bodies arranged in an array.

After the plurality of MOSFET assemblies 200 are manufactured, the wafer serving as the chip body 110 of the carrier chip 100 is provided. The wafer may be divided into a plurality of regions in an array, and each region corresponds to a chip body 110 of one carrier chip 100. The chip body 110 is provided with a conductive structure.

S300: Form a dielectric layer and a wiring layer on a surface on one side of the wafer.

Then, a dielectric layer 120 and a wiring layer 130 are formed on the surface on one side of the wafer to provide a fixed foundation for the MOSFET chip 210 and implement a connection between the MOSFET chip 210 and the conductive structure in the chip body 110. The wafer serves as the chip body 110 of the carrier chip 100, and together with the dielectric layer 120 and the wiring layer 130, forms the carrier chip 100. After the dielectric layer 120 and the wiring layer 130 are formed on the wafer, the wafer is cut to form independent carrier chips 100.

In this embodiment, after the dielectric layer 120 and the wiring layer 130 are formed on the wafer, the MOSFET assemblies 200 may be packaged on the wafer first, and then the wafer is cut to form a plurality of separate MOSFET packaging structures 10. In this way, wafer-level chip packaging is implemented. In a conventional chip packaging manner, cutting is performed first and then packaging is performed, and an area after packaging is increased by at least 20% of a die (a single carrier chip 100). In wafer-level chip packaging, packaging and testing are completed on an entire wafer, and then cutting is performed to form separate MOSFET packaging structures 10, so that an area after packaging is the same as an area of a die, and miniaturization of the MOSFET packaging structure 10 can be implemented.

The formed dielectric layer 120 covers a surface of the wafer. The wiring layer 130 is located in the dielectric layer 120. The wiring layer 130 has a plurality of conductive wires 131. One side of the conductive wires 131 facing the wafer is electrically connected to the wafer, and a surface on one side of the conductive wires 131 facing away from the wafer has an exposed region. The exposed region is exposed outside the dielectric layer 120 and used for forming the foregoing first pad 102, so as to implement connection between the carrier chip 100, the MOSFET chip 210, and the circuit board 20 through the first pad 102.

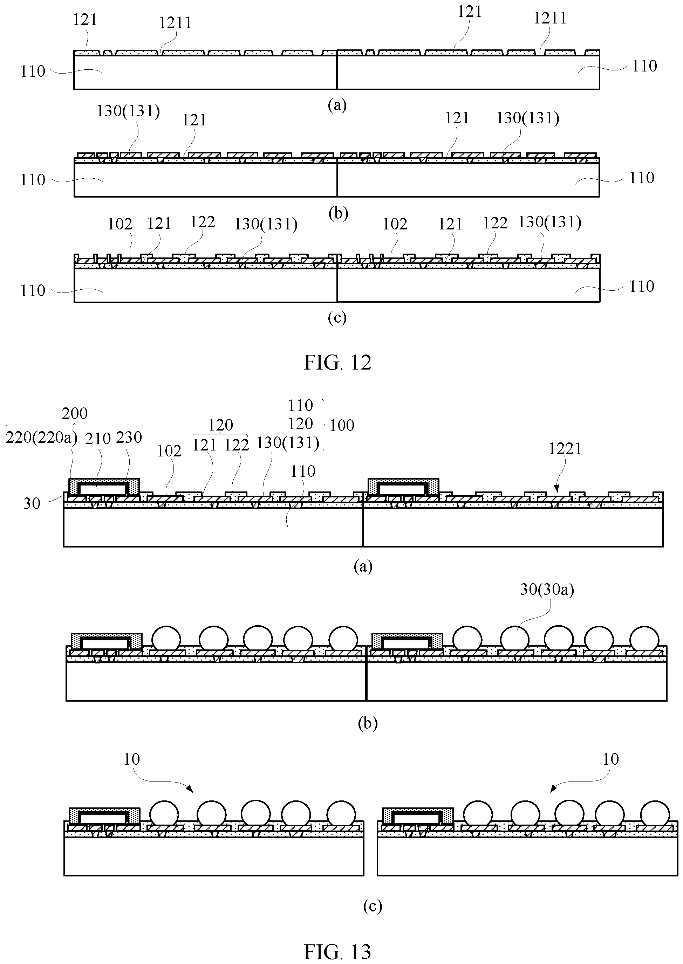

FIG. 12 is a schematic diagram of forming a dielectric layer and a wiring layer on a wafer according to an embodiment of this application. As shown in FIG. 12, the forming the dielectric layer 120 and the wiring layer 130 on the surface of the wafer specifically includes the following.

As shown in FIG. 12(a), an insulating first dielectric layer 121 is first formed on the surface of the wafer. Through holes 1211 are provided in the first dielectric layer 121. The through holes 1211 penetrate a thickness direction of the first dielectric layer 121 to expose a partial region of the surface of the wafer outside the first dielectric layer 121. For example, the first dielectric layer 121 may be deposited on the surface of the wafer, and then the through holes 1211 may be etched in the first dielectric layer 121. The first dielectric layer 121 may be, for example, a silicon oxide layer or a silicon nitride layer.

As shown in FIG. 12(b), after the first dielectric layer 121 is formed on the surface of the wafer, the wiring layer 130 is laid on the first dielectric layer 121. There are gaps between the conductive wires 131 in the wiring layer 130, and the conductive wires 131 are electrically isolated from each other. Portions of the conductive wires 131 corresponding to the through holes 1211 extend into the through holes 1211 and are in contact with the surface of the wafer through the through holes 1211, so that the conductive wires 131 are electrically connected to the wafer. For example, an entire metal layer may be deposited on a surface of the first dielectric layer 121, and then the metal layer may be etched to form a plurality of mutually isolated conductive wires 131.

As shown in FIG. 12(c), after the wiring layer 130 is formed, an insulating second dielectric layer 122 is formed on the wafer. The second dielectric layer 122 is formed on the first dielectric layer 121, and the second dielectric layer 122 covers the wiring layer 130 to protect the wiring layer 130. In addition, the second dielectric layer 122 has an opening 1221, and a partial region of the conductive wires 131 in the wiring layer 130 is exposed in the opening 1221. The exposed region of the conductive wires 131 is used to form the first pad 102. For example, one second dielectric layer 122 may be deposited on the first dielectric layer 121 first, and the second dielectric layer 122 covers the wiring layer 130. Then, the second dielectric layer 122 is etched to form the opening 1221. The second dielectric layer 122 is, for example, a silicon oxide layer or a silicon nitride layer.

S400: Mount the MOSFET assemblies on the wafer, and first surfaces of the MOSFET chips are connected to the first pads through conductive materials.

FIG. 13 is a schematic diagram of forming a MOSFET packaging structure according to an embodiment of this application. As shown in FIG. 13(a), after the dielectric layer 120 and the wiring layer 130 are laid on the wafer, assembled MOSFET assemblies 200 are packaged on the wafer. Conductive materials 30 may be first provided on the first pads 102 in the mounting regions 101a corresponding to the carrier chips 100 on the wafer, and then the MOSFET assemblies 200 are mounted on the first pads 102 in the mounting regions 101a. The first surface 210a of the MOSFET chip 210 faces the carrier chip 100 and is attached to the first pad 102 in the mounting region 101a of the carrier chip 100.

Specifically, each conductive gasket 213 on the first surface 210a of the MOSFET chip 210 is connected to each corresponding first pad 102 through the conductive material 30. In the case that the input gasket 211, the output gasket 212, and the ground gasket of the MOSFET chip 210 are all provided on a side on which the first surface 210a of the MOSFET chip 210 is located, the mounting region 101a of the carrier chip 100 is provided with an input pad 102a, an output pad 102b, and the ground pad respectively corresponding to the input gasket 211, the output gasket 212, and the ground gasket. Each conductive frame 220a mounted on the MOSFET chip 210 is connected to the corresponding input pad 102a, the output pad 102b, and the ground pad through the conductive material 30.

As shown in FIG. 13(b), in order to implement a connection between the MOSFET packaging structure 10 and the circuit board 20, after the MOSFET assemblies 200 are mounted on the wafer and before the wafer is cut, the conductive materials 30 may be first provided on the first pads 102 on the carrier chips 100 on the wafer. For example, solder balls 30a may be printed on the first pads 102 as the conductive materials 30. In this way, after the wafer is cut subsequently, the MOSFET packaging structure 10 may be directly mounted on the circuit board 20, and the MOSFET packaging structure 10 and the circuit board 20 are connected through the conductive material 30.

Alternatively, in another implementation, the conductive materials 30 may alternatively be pre-disposed on the circuit board 20. For example, the solder balls 30a are pre-printed on the second pads 23 on the circuit board 20, and after the wafer is cut, the formed MOSFET packaging structure 10 is mounted on the circuit board 20.

S500: Cut the wafer to form separate MOSFET packaging structures.

After the MOSFET assembly 200 is mounted on the wafer, the wafer is cut and the corresponding carrier chips 100 on the wafer are separated. After separation, each carrier chip 100 and the MOSFET assembly 200 mounted on the carrier chip 100 form separate MOSFET packaging structures 10. In this way, through the wafer-level chip packaging manner, the volume of the MOSFET packaging structure 10 is reduced, which is conducive to miniaturization of the MOSFET packaging structure 10. In addition, packaging process steps are simplified, packaging costs are reduced, and packaging efficiency is improved.

In the descriptions of embodiments of this application, it should be noted that, unless otherwise explicitly stipulated and restricted, terms "installation", "joint connection", and "connection" should be understood broadly, which, for example, may be fixed connection, or may be indirect connection through a medium, or may be internal communication between two components, or may be an interactive relationship between two components. For a person of ordinary skill in the art, specific meanings of the foregoing terms in embodiments of this application may be understood based on specific circumstances.

In the specification, the claims, and the foregoing accompanying drawings of embodiments of this application, the terms "first', "second" "third", "fourth", and the like (if existing) are used to distinguish between similar objects, but do not limit a particular order or sequence.

## Claims

1. A MOSFET packaging structure, comprising a carrier chip, a MOSFET chip, and three conductive members;
a surface on one side of the carrier chip is a mounting surface, a plurality of first pads are distributed on the mounting surface, the mounting surface has a mounting region, the plurality of first pads are provided in the mounting region, the MOSFET chip has a first surface and a second surface opposite to each other, the first surface is mounted in the mounting region and connected to the first pads in the mounting region, and the three conductive members are all mounted on the second surface at intervals; and
the MOSFET chip comprises an input gasket, an output gasket, and a ground gasket, and the three conductive members are electrically connected to the input gasket, the output gasket, and the ground gasket respectively.

2. The MOSFET packaging structure according to claim 1, wherein the input gasket, the output gasket, and the ground gasket are all located on a side on which the first surface is located, the first pads in the mounting region comprise an input pad, an output pad, and a ground pad, the input gasket is correspondingly connected to the input pad, the output gasket is correspondingly connected to the output pad, and the ground gasket is correspondingly connected to the ground pad.

3. The MOSFET packaging structure according to claim 2, wherein the conductive member is a conductive frame, the conductive frame comprises a main plate portion and side plate portions, the main plate portion covers the second surface, one end of each of the side plate portions is connected to a side edge of the main plate portion, and the other end of the side plate portion extends toward the carrier chip; and
side plate portions of three conductive frames are respectively connected to the input pad, the output pad, and the ground pad.

4. The MOSFET packaging structure according to claim 3, wherein an adhesive layer is provided between the conductive frame and the MOSFET chip.

5. The MOSFET packaging structure according to claim 3 or 4, wherein the conductive frame comprises a copper frame or a copper alloy frame.

6. The MOSFET packaging structure according to claim 1, wherein the input gasket, the output gasket, and the ground gasket are all located on a side on which the second surface is located, and the three conductive members respectively cover the input gasket, the output gasket, and the ground gasket.

7. The MOSFET packaging structure according to claim 6, wherein the conductive member is a conductive layer covering the second surface.

8. The MOSFET packaging structure according to claim 7, wherein the conductive layer comprises a copper layer or an aluminum layer.

9. The MOSFET packaging structure according to any one of claims 1 to 8, wherein a plurality of conductive gaskets are also distributed on the first surface, and the conductive gaskets are connected to the first pads in the mounting region in a one-to-one correspondence.

10. The MOSFET packaging structure according to any one of claims 1 to 9, wherein the MOSFET chip is a GaN MOSFET.

11. The MOSFET packaging structure according to any one of claims 1 to 10, wherein the carrier chip comprises a chip body, a dielectric layer, and a wiring layer; and
the dielectric layer covers the chip body, the wiring layer is provided in the dielectric layer, a side of the wiring layer facing the chip body is connected to a conductive structure in the chip body, a surface on a side of the wiring layer facing away from the chip body has an exposed region exposed outside the dielectric layer, and the first pad corresponds to the exposed region.

12. The MOSFET packaging structure according to claim 11, wherein the dielectric layer comprises a first dielectric layer and a second dielectric layer successively stacked on the chip body, and the wiring layer is provided between the first dielectric layer and the second dielectric layer, wherein
through holes are provided in the first dielectric layer, and the wiring layer is connected to the conductive structure through the through holes; and the second dielectric layer has an opening, and the exposed region is exposed in the opening.

13. A manufacturing method of a MOSFET packaging structure, comprising:
providing a plurality of MOSFET assemblies, wherein the MOSFET assemblies each comprise a MOSFET chip and three conductive members, the MOSFET chip has a first surface and a second surface opposite to each other, the three conductive members are all mounted on the second surface at intervals, the MOSFET chip comprises an input gasket, an output gasket, and a ground gasket, and the three conductive members are electrically connected to the input gasket, the output gasket, and the ground gasket respectively;
providing a wafer, wherein the wafer comprises a plurality of chip bodies arranged in an array;
forming a dielectric layer and a wiring layer on a surface on one side of the wafer, wherein the dielectric layer covers the wafer, the wiring layer is provided in the dielectric layer, a side of the wiring layer facing the wafer is connected to conductive structures in the chip bodies, a surface on a side of the wiring layer facing away from the wafer has exposed regions exposed outside the dielectric layer, and the exposed regions form first pads correspondingly;
mounting the MOSFET assemblies on the wafer, wherein first surfaces of the MOSFET chips are connected to the first pads through conductive materials; and
cutting the wafer to form separate MOSFET packaging structures.

14. The manufacturing method of a MOSFET packaging structure according to claim 13, wherein the input gasket, the output gasket, and the ground gasket are all located on a side on which the first surface is located, and the providing MOSFET assemblies comprises:
providing a conductive frame as the conductive member, wherein the conductive frame comprises a main plate portion and side plate portions, one end of each of the side plate portions is connected to a side edge of the main plate portion, and the other end of the side plate portion faces a side of the main plate portion; and
connecting the MOSFET chip to the conductive frame, wherein the MOSFET chip is located in a region enclosed by the main plate portion part and the side plate portions.

15. The manufacturing method of a MOSFET packaging structure according to claim 14, wherein the providing a plurality of MOSFET assemblies comprises:
providing a conductive plate;
processing the conductive plate to form a plurality of interconnected conductive frames;
correspondingly connecting each MOSFET chip to each conductive frame; and
cutting the conductive plate to form the plurality of MOSFET assemblies.

16. The manufacturing method of a MOSFET packaging structure according to claim 15, wherein the processing the conductive plate comprises:
using a photolithography process or a stamping for molding process to form the plurality of interconnected conductive frames on the conductive plate.

17. The manufacturing method of a MOSFET packaging structure according to claim 13, wherein the input gasket, the output gasket, and the ground gasket are all located on a side on which the second surface is located, and the providing MOSFET assemblies comprises:
providing the MOSFET chip; and
forming a conductive layer on the second surface of the MOSFET chip, wherein the conductive layer serves as a conductive member, and three conductive layers cover the input gasket, the output gasket, and the ground gasket respectively.

18. The manufacturing method of a MOSFET packaging structure according to any one of claims 13 to 17, wherein the forming a dielectric layer and a wiring layer on a surface on one side of the wafer comprises:
forming a first dielectric layer having through holes on the surface on one side of the wafer;
laying the wiring layer on the first dielectric layer, wherein the wiring layer is connected to the conductive structure through the through holes; and
forming a second dielectric layer having an opening on the first dielectric layer, wherein the second dielectric layer covers the wiring layer, and the exposed region is exposed in the opening.

19. A circuit board assembly, comprising a circuit board and the MOSFET packaging structure according to any one of claims 1 to 12, a plurality of second pads are distributed on the circuit board, and the MOSFET packaging structure is connected to the second pad through a conductive material.

20. An electronic device, comprising a housing and the circuit board assembly according to claim 19, wherein the circuit board assembly is disposed inside the housing.
